# EUROPEAN PATENT APPLICATION

(11) **EP 2 282 607 A1**
(43) Date of publication of application: **09.02.2011**
(21) Application number: 09728951.6
(22) Date of filing: 18.03.2009
(51) Int. Cl.: H05B 33/04, H01L 51/50, H05B 33/02

(54) **ORGANIC ELECTROLUMINESCENT DEVICE**

(30) Priority: 31.03.2008 JP 2008091414
(71) Applicant: Sumitomo Chemical Company, Limited, Tokyo 104-8260 (JP)
(72) Inventor: SASSA, Shuichi, Tsukuba-shi Ibaraki 305-0821 (JP)
(74) Representative: Duckworth, Timothy John
(86) International application number: PCT/JP2009/055263
(87) International publication number: WO 2009/122909

(57) **Abstract**

An organic electroluminescent element comprises a supporting substrate, a sealing substrate, and a layered body including a pair of electrodes and an organic light-emitting layer located between the electrodes, in which the layered body is mounted on the supporting substrate and is surrounded by the supporting substrate and the sealing substrate to be isolated from the external environment, a highly thermally radiative layer is provided on at least one face of the supporting substrate and at least one face of the sealing substrate, or the highly thermally radiative layer has a thermal emissivity of equal to or more than 0.7.

## Description

### TECHNICAL FIELD

The present invention relates to an organic electroluminescent element (hereinafter, also referred to as an "organic EL element"), and specifically relates to an organic electroluminescent element that comprises an anode, a cathode, and a light-emitting layer containing an organic compound mounted on a substrate.

### BACKGROUND ART

Various studies of organic EL elements and organic EL devices have been performed in which the organic EL elements are mounted so as to develop devices that provide a higher level of performance. Generally, an organic EL element comprises an anode, a cathode, and a light-emitting layer located between the anode and the cathode. The light-emitting layer is composed of an organic compound that emits light when voltage is applied. The organic EL elements have various properties, and one major feature is that the elements can be extremely thin devices because the elements can be formed by laminating thin films.

Although the organic EL elements emit light when voltage is applied, a part of the light emission is converted into thermal energy under the present circumstances, and the organic EL elements may generate heat due to Joule heat and similar factors. The heat generation of the organic EL elements may decrease the light-emitting properties such as brightness or may cause deterioration of the organic EL elements themselves. The deterioration of the organic EL elements tends to occur more readily in correspondence with the increase in temperature of the organic EL elements. Illumination devices in which the organic EL devices are used and that are desired for practical use, for example, are needed to be driven so as to emit light with high brightness. Therefore, the manner in which heat is released from the devices has been an important issue. Accordingly, various measures to dissipate heat generated from the organic EL elements to the exterior of the elements have been investigated.

A method of employing a material having a high thermal conductivity as a part of the members is disclosed as a method of improving heat dissipation properties (for example, Patent Document 1). Providing a heat dissipation film at a portion in the internal structure of an organic EL element is also disclosed (for example, Patent Document 2).

Patent Document 1: JP 2004-186045 A
Patent Document 2: JP 2006-244847 A

### DISCLOSURE OF INVENTION

### PROBLEM TO BE SOLVED BY THE INVENTION

However, even when a heat radiation layer is provided at a portion of the internal structure of an organic EL element, for example, at a side surface of a light-emitting layer or at a partition portion that sections each element, there is only a small contact area of the heat radiation layer with the layered body unit that comprises the light-emitting layer. The effect of heat transfer is not sufficient with such a small area.

Given such conditions, an object of the present invention is to provide an organic EL element with further improved heat dissipation properties.

### MEANS FOR SOLVING PROBLEM

A layered body that comprises a pair of electrodes (that is, an anode and a cathode) and a light-emitting layer provided between the pair of electrodes and that constitutes an organic EL element is formed by stacking each layer on a substrate. Although glass is widely used for the substrate, glass thermal conductivity is generally 1 W/m•K, which is low, and therefore, it is difficult to conduct generated heat from inside of the glass to the exterior. Moreover, glass does not readily diffuse heat in a uniform manner, and therefore, deviation in heat distribution may occur in a glass substrate. As a result, the organic EL element and a device on which the organic EL element is mounted may have different properties such as brightness fluctuation and variations of product life. The present inventors considered implementing measures against heat by, for example, attaching a plate with a high thermal conductivity to the surface of glass to achieve uniform temperature distribution at the surface of the glass (thermal uniformity).

By attaching a sheet having a high thermal conductivity, heat possessed by the glass substrate is diffused, thereby achieving uniform temperature distribution at the surface of the glass substrate. As a result, accelerated degradation at only a portion due to extreme increase in temperature at that portion can be prevented; however, further improvements to the release of heat from the element itself to the exterior are required.

The present invention has achieved the suppression of temperature increase of the organic EL element by providing at the substrate, a coating layer, a sheet, or the like that provides not only superior thermal conductivity but also has excellent heat dissipation properties that can significantly enhance heat radiation from the substrate to the exterior. In other words, the present invention provides an organic EL element that has a structure described below and a device on which an organic EL element is mounted.

[1] An organic electroluminescent element comprising a supporting substrate, a sealing substrate, and a layered body comprising a pair of electrodes and an organic light-emitting layer located between the electrodes,
   wherein the layered body is mounted on the supporting substrate and is surrounded by the supporting substrate and the sealing substrate to be isolated from an external environment,
   a highly thermally radiative layer is provided on at least one face of the supporting substrate, or at least one face of the sealing substrate, and
   the highly thermally radiative layer has a thermal emissivity of equal to or more than 0.70.
[2] The organic electroluminescent element according to above [1], wherein the thermal emissivity is equal to or more than 0.85.
[3] The organic electroluminescent element according to the above [1] or [2], wherein the thermal conductivity of the highly thermally radiative layer is equal to or more than 1 W/mK.
[4] The organic electroluminescent element according to above [3], wherein the thermal conductivity is equal to or more than 200 W/mK.
[5] The organic electroluminescent element according to any one of the above [1] to [4], wherein the highly thermally radiative layer comprises a black material.
[6] The organic electroluminescent element according to any one of the above [1] to [5], wherein the highly thermally radiative layer is a laminated layer having two or more layers that comprise a highly thermally conductive layer and a layer of a black material.
[7] The organic electroluminescent element according to above [6], wherein the highly thermally conductive layer is composed of a material selected from the group consisting of aluminum, copper, silver, ceramic materials, and alloys that contains two or more members selected from these or resin having a high thermal conductivity.
[8] The organic electroluminescent element according to any one of the above [1] to [7], wherein the supporting substrate is a glass substrate, and the highly thermally radiative layer is provided on at least one face of the glass substrate.
[9] The organic electroluminescent element according to any one of above [8], wherein the highly thermally radiative layer is provided on a face of the glass substrate on a side opposite to the layered body.
[10] The organic electroluminescent element according to above [8], wherein the highly thermally radiative layer is provided on both faces of the glass substrate.
[11] The organic electroluminescent element according to above [8], wherein the highly thermally radiative layer is provided on a face of the glass substrate on a side opposite to the layered body, and a highly thermally conductive layer is provided on a face of the glass substrate on a side of the layered body.
[12] The organic electroluminescent element according to the above [1] to [7], wherein the sealing substrate is a glass substrate, and the highly thermally radiative layer is provided on at least one face of the glass substrate.
[13] A display device comprising the organic electroluminescent element according to any one of the above [1] to [12] mounted thereon.
[14] An illumination device comprising the organic electroluminescent element according to any one of the above [1] to [12] mounted therein.

### EFFECT OF THE INVENTION

The present invention can provide an organic EL element and an organic EL device that have simple structures and excellent heat dissipation properties.

### BRIEF DESCRIPTION OF DRAWINGS

[Fig. 1] Fig. 1 is a sectional schematic of an organic EL element of a first embodiment of the present invention.
[Fig. 2] Fig. 2 is a sectional schematic of an organic EL element of a second embodiment of the present invention.
[Fig. 3-1] Fig. 3-1 is a sectional schematic of a third embodiment of the present invention.
[Fig. 3-2] Fig. 3-2 is a sectional schematic of a modified example of the third embodiment of the present invention.
[Fig. 3-3] Fig. 3-3 is a sectional schematic of another modified example of the third embodiment of the present invention.

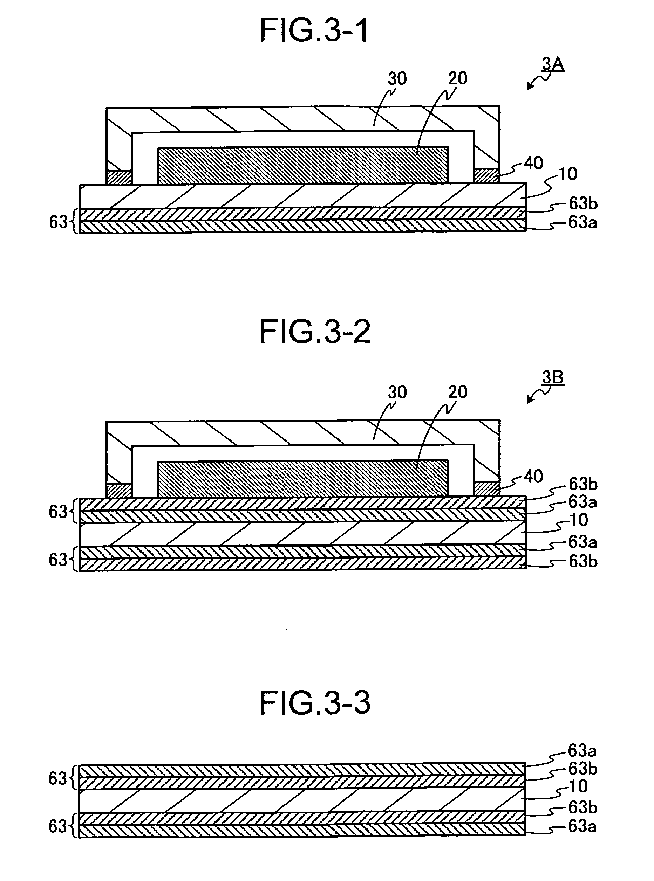

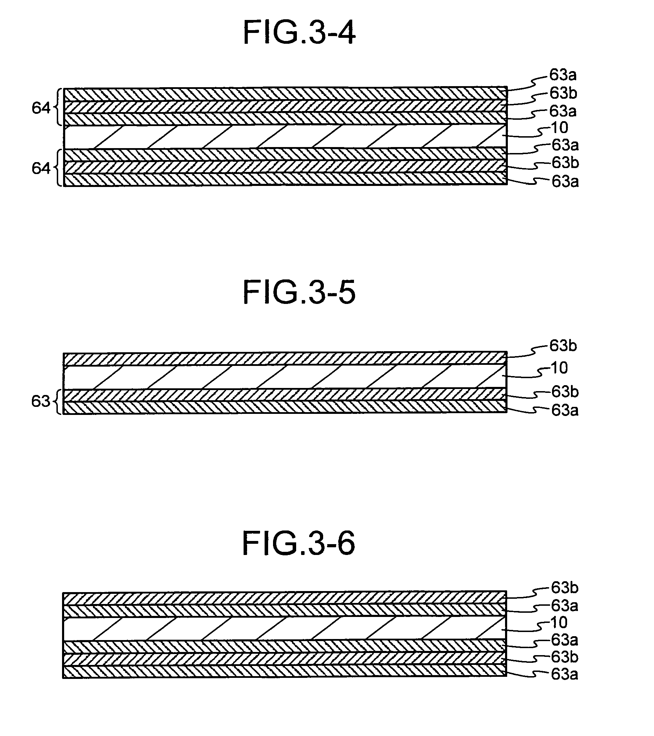

[Fig. 3-4] Fig. 3-4 is a sectional schematic of another modified example of the third embodiment of the present invention.
[Fig. 3-5] Fig. 3-5 is a sectional schematic of another modified example of the third embodiment of the present invention.
[Fig. 3-6] Fig. 3-6 is a sectional schematic of another modified example of the third embodiment of the present invention.

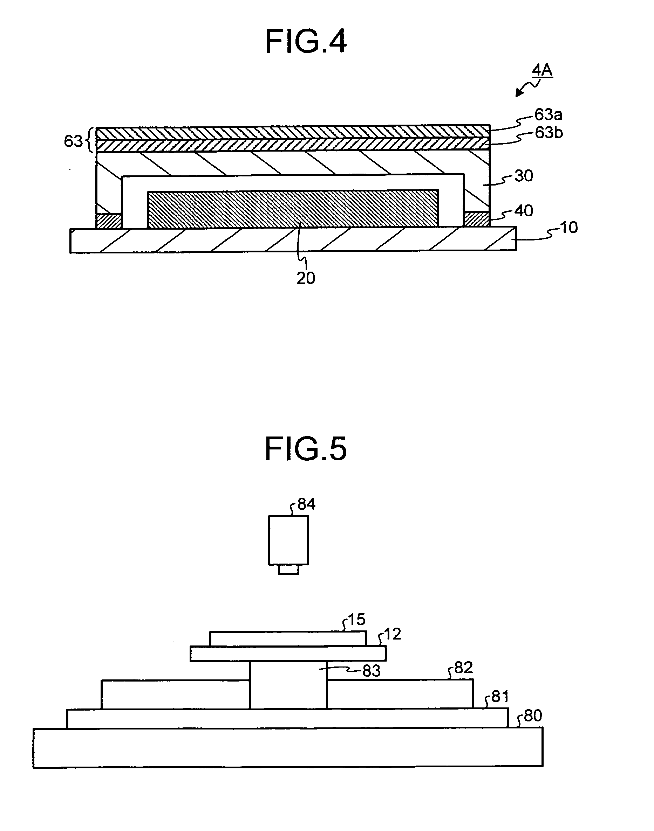

[Fig. 4] Fig. 4 is a sectional schematic of a fourth embodiment of the present invention.
[Fig. 5] Fig. 5 is a schematic of a side surface of an experimental apparatus for verification.

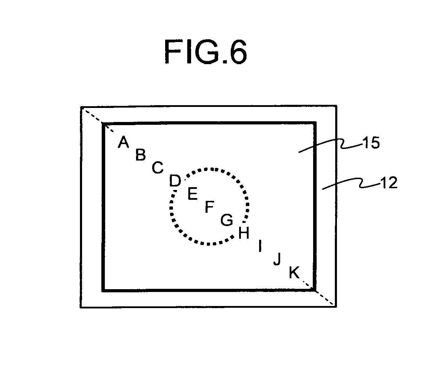

[Fig. 6] Fig. 6 is a plane schematic of a test substrate placed on the experimental apparatus for verification and measurement positions.

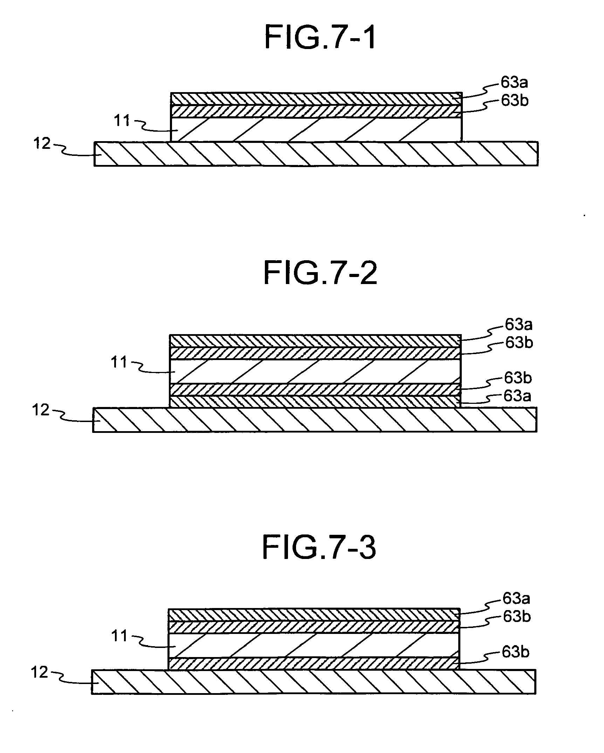

[Fig. 7-1] Fig. 7-1 is a sectional schematic of a test substrate subjected to Test Example 1.
[Fig. 7-2] Fig. 7-2 is a sectional schematic of a test substrate subjected to Test Example 2.
[Fig. 7-3] Fig. 7-3 is a sectional schematic of a test substrate subjected to Test Example 3.

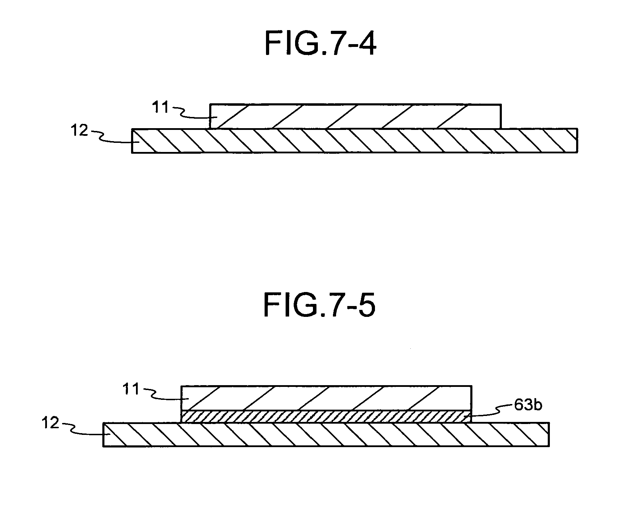

[Fig. 7-4] Fig. 7-4 is a sectional schematic of a test substrate subjected to Comparative Test Example 1.
[Fig. 7-5] Fig. 7-5 is a sectional schematic of a test substrate subjected to Comparative Test Example 2.

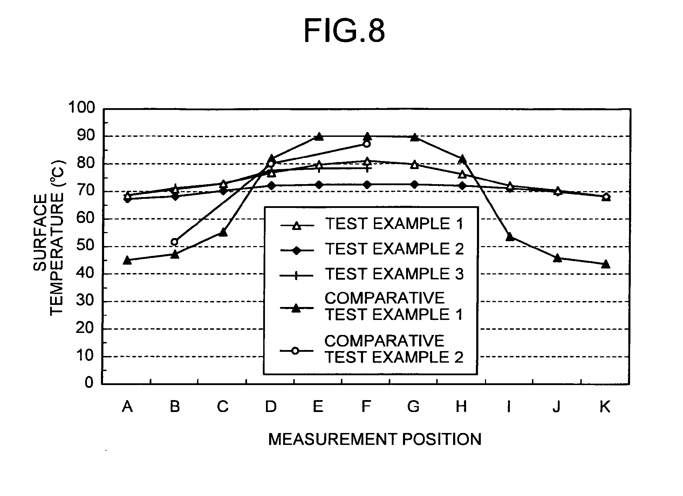

[Fig. 8] Fig. 8 is a graph for a test result of verification.

### EXPLANATIONS OF LETTERS OR NUMERALS

- 1, 2, 3A, 3B, 4A: organic EL element
- 10: supporting substrate
- 11: glass substrate
- 12: test substrate supporting glass
- 15: test substrate
- 20: layered body comprising an organic light-emitting layer
- 30, 31: sealing substrate
- 40: adhesive portion
- 60, 61: highly thermally radiative layer
- 63: two-layered highly thermally conductive and radiative layer
- 63a: black coating layer
- 63b: aluminum layer
- 64: three-layered highly thermally conductive and radiative layer
- 80: test board
- 81: hot plate
- 82: thermal insulating sheet
- 83: heat conducting portion (heat source, brass)
- 84: temperature sensor
- A to K: (in Fig. 6) measurement position

### BEST MODE(S) FOR CARRYING OUT THE INVENTION

Embodiments of the present invention are described below with reference to the accompanying drawings. To facilitate understanding, the scale of each member in the drawings may be different from its actual scale. The present invention is not limited by the following description. Changes and modifications can be made appropriately without departing from the spirit and scope of the present invention. Although an organic EL device has members such as a lead wire of electrodes, the description is omitted because such members are not directly needed to describe the present invention.

### 1. Organic EL element

### <First embodiment>

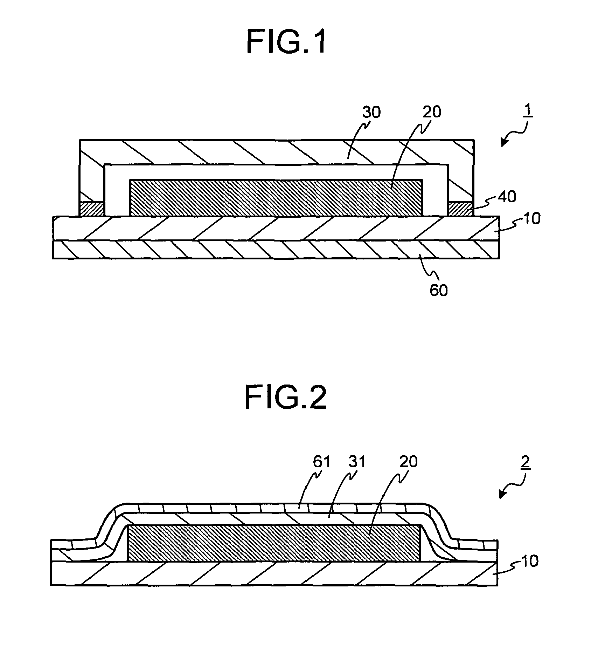

The first embodiment of the present invention is described with reference to Fig. 1. Fig. 1 is a sectional schematic of an organic EL element 1 of the first embodiment (hereinafter, referred to as an "element of the first embodiment"). In the element of the first embodiment, a layered body 20 including an organic light-emitting layer is formed on a supporting substrate 10. The whole of the layered body 20 is covered with a sealing substrate 30, and the sealing substrate 30 and the supporting substrate 10 are sealed at a adhesive portion 40. With such a structure, the layered body 20 is isolated from the external environment. A highly thermally radiative layer 60 is provided on the face outside of the supporting substrate 10, that is, at the face opposite to the side on which the layered body 20 is formed.

In the organic EL element 1, heat generated in the element is diffused in the substrate to promote uniform heating, and a heat radiation mechanism is provided to more actively release heat from the supporting substrate 10 to the external environment. With this mechanism, the element releases heat to the external environment more actively than an element in which the layer is composed of a material simply having a high thermal conductivity, and this creates an enormous effectiveness in suppressing temperature increase in the element. Moreover, a structure in which the heat radiation mechanism is provided to be attached to the supporting substrate is employed. Therefore, the internal structure of the organic EL element, which could be, for example, a structure design of a layered body including an organic light-emitting layer, a partition (bank) that sections the layered body, does not need to be complicated, resulting in an element having a simple structure.

### <Substrate>

The substrates that constitute the organic EL element 1 include the supporting substrate 10 and the sealing substrate 30. The layered body 20 is mounted on one face of the supporting substrate 10. The sealing substrate 30 covers the layered body 20 on the supporting substrate 10 to seal the element. For a material that constitutes each substrate, any material is applicable as long as it remains unchanged when electrodes and the like, and layers of organic substances are formed. Examples of the material available may include glass, plastic, a polymer film, a silicon substrate, a metal plate, and a laminate of such materials. Moreover, plastic, a polymer film, or other material that is subjected to low permeability treatment may also be used. The substrate is commercially available or may be manufactured by a publicly known method. A suitable shape of the supporting substrate 10 is a plane shape that has an area on which the layered body 20 can be mounted. The shape of the sealing substrate 30 may be the shape that allows the layered body 20 to be sealed by bonding the sealing substrate 30 with the supporting substrate 10. The shape may be a box shape as illustrated in Fig. 1 or a flat plate shape (not illustrated).

Although examples of the material that may be used for the substrates in the organic EL element 1 include such materials as described above, a glass substrate is suitable in terms of ease of handling. However, a glass substrate is a material having a low thermal radiation property. The present invention can improve heat dissipation properties and, therefore, can be suitable for use when a material having low heat dissipation properties such as a glass substrate is used as a substrate.

### <Highly thermally conductive and radiative layer>

A highly thermally radiative layer is preferably a layer composed of a material that is high in two types of properties against heat, that is, both thermal conductivity and thermal radiation properties (hereinafter, also referred to as a "highly thermally conductive and radiative layer"). In this specification, conduction of heat refers to a phenomenon in which heat transfers from a high temperature portion to a low temperature portion without the movement of an object and energy transport due to radiation *(Iwanami Rikagaku Jiten* (Iwanami's Dictionary of Physics and Chemistry), 5th ed., Iwanami Shoten publishers, 1998). Thermal radiation refers to a phenomenon in which an object releases thermal energy as electromagnetic waves, or means electromagnetic waves themselves *(Iwanami Rikagaku Jiten* (Iwanami's Dictionary of Physics and Chemistry), same as above).

The preferable thermal emissivity of a material having a high thermal radiation property is, for example, equal to or more than 0.70, and more preferably, equal to or more than 0.85. From the viewpoint of releasing heat, the upper limit of the thermal emissivity does not need to be specifically defined. Thermal emissivity refers to the ratio of the amount of energy radiated from the surface of a substance at a certain temperature and the amount of energy radiated from a black body (imaginary substance that absorbs 100 percent of the energy imparted by radiation) at the same temperature. Thermal emissivity may be measured by Fourier transform infrared spectroscopy (FT-IR). Examples of a material having a high thermal radiation property may include a black material, and pigment components of black paint or the like, and these are suitable for use. Examples of the black material may include carbon plastic, TiO₂ and Fe₃O₄.

The preferable thermal conductivity of a material having a high thermal conductivity is, for example, equal to or more than 1 W/mK, more preferably, equal to or more than 10 W/mK, and further preferably, equal to or more than 200 W/mK. From the viewpoint of releasing heat, the upper limit of the thermal conductivity does not need to be specifically defined. Thermal conductivity refers to the ratio of an amount of heat that vertically flows through a unit area of an isothermal surface inside of an object per unit time and a temperature gradient in this direction *(Iwanami Rikagaku Jiten* (Iwanami's Dictionary of Physics and Chemistry), same as above). Thermal conductivity may be measured by, for example, a method of American Society for Testing and D5470 (ASTM D5470). Examples of a material having a high thermal conductivity may include aluminum, copper, silver, ceramic materials, and resin having high thermal conductivity. Examples of resin having a high thermal conductivity may include epoxy resin, melamine resin, and acrylic resin.

The highly thermally conductive and radiative layer may be formed in a single layer, or may have two or more plural layers. When the layer is a single layer, an embodiment of forming a layer by dispersing highly thermally conductive fine particles and mixing black pigment with resin material, and applying this resin material to a substrate may be employed.

The highly thermally conductive and radiative layer that comprises a plurality of layers may be formed by, for example, applying paint that contains black pigment to one face or both faces of a sheet material having high thermal conductivity, producing a complex sheet in which a coating of a material having a high thermal radiation property is formed on a sheet having high thermal conductivity, and laminating the complex sheet with a substrate. A complex sheet in which a sheet material having a high thermal conductivity and a sheet material having a thermal radiation property are laminated may be used as other embodiments. Both the highly thermally conductive layers and highly thermally radiative layers may be laminated in pluralities.

When a highly thermally conductive and radiative sheet layer is provided on a substrate, an adhesive may be used to perform a bonding process. When an adhesive is used, an adhesive having a high thermal conductivity such as an acrylic adhesive or an epoxy adhesive may be suitable for use. For a glass substrate, an adhesive such as an acrylic adhesive may be suitable for use due to their excellent glass adhesion properties.

The layered body 20 including an organic light-emitting layer can employ various embodiments that may be constituted as organic EL elements in general. Embodiments of a layered structure of a layered body that can be used as the layered body 20 including an organic light-emitting layer, a forming method of the layered structure, and the like are described below.

The layered body mounted on the organic EL element necessarily comprises an anode, a light-emitting layer, and a cathode, and may further comprise other layers at any one of a position between the anode and the light-emitting layer and a position between the light-emitting layer and the cathode or both.

A layer which may be provided at a position between the cathode and the light-emitting layer may include an electron injection layer, an electron transport layer, and a hole block layer. When both the electron injection layer and the electron transport layer are provided, the layer closer to the cathode is the electron injection layer, and the layer closer to the light-emitting layer is the electron transport layer.

The electron injection layer is a layer that functions to improve electron injection efficiency from the cathode, and the electron transport layer is a layer that functions to improve electron injection from the cathode, the electron injection layer, or the electron transport layer closer to the cathode. When the electron injection layer or the electron transport layer functions to block hole transport, these layers may also serve as hole block layers.

A layer which is provided at a position between the anode and the light-emitting layer may include a hole injection layer, a hole transport layer, and an electron block layer. When both the hole injection layer and the hole transport layer are provided, the layer closer to the anode is the hole injection layer, and the layer closer to the light-emitting layer is the hole transport layer.

The hole injection layer is a layer that functions to improve hole injection efficiency from the anode, and the hole transport layer is a layer that functions to improve hole injection from the anode, the hole injection layer, or the hole transport layer closer to the anode. When the hole injection layer or the hole transport layer functions to block electron transport, these layers may also serve as electron block layers.

The electron injection layer and the hole injection layer may be generically referred to as charge injection layers. The electron transport layer and the hole transport layer may be generically referred to as charge transport layers. The electron block layer and the hole block layer may be generically referred to as charge block layers.

More specifically, the organic EL element may comprise any of the following layered structures.
a) anode/hole injection layer/hole transport layer/light-emitting layer/electron transport layer/electron injection layer/cathode
b) anode/hole injection layer/hole transport layer/light-emitting layer/electron transport layer/cathode
c) anode/hole injection layer/hole transport layer/light-emitting layer/electron injection layer/cathode
d) anode/hole injection layer/hole transport layer/light-emitting layer/cathode
e) anode/hole injection layer/light-emitting layer/electron transport layer/electron injection layer/cathode
f) anode/hole injection layer/light-emitting layer/electron transport layer/cathode
g) anode/hole injection layer/light-emitting layer/electron injection layer/cathode
h) anode/hole injection layer/light-emitting layer/cathode
i) anode/hole transport layer/light-emitting layer/electron transport layer/electron injection layer/cathode
j) anode/hole transport layer/light-emitting layer/electron transport layer/cathode
k) anode/hole transport layer/light-emitting layer/electron injection layer/cathode
l) anode/hole transport layer/light-emitting layer/cathode
m) anode/light-emitting layer/electron transport layer/electron injection layer/cathode
n) anode/light-emitting layer/electron transport layer/cathode
o) anode/light-emitting layer/electron injection layer/cathode
p) anode/light-emitting layer/cathode
(A forward slash (/) denotes that each layer is adjacently stacked. The same meaning shall apply, hereinafter.)

In each example of the layered structure, an electron block layer may be inserted at a position between the light-emitting layer and the anode. A hole block layer may also be inserted at a position between the light-emitting layer and the cathode.

While an organic EL element generally comprises the light-emitting layer as a single layer, this is not limited thereto. Two or more light-emitting layers may be provided instead. In this case, the two or more light-emitting layers may be directly laminated to be in contact with each other, or layers other than light-emitting layers may be provided at a position between such light-emitting layers.
Examples of an organic EL element comprising two light-emitting layers may include an organic EL element that has the following layered structure.
q) anode/hole injection layer/hole transport layer/light-emitting layer/electron transport layer/electron injection layer/electrode/hole injection layer/hole transport layer/light-emitting layer/electron transport layer/electron injection layer/cathode

Specific examples of an organic EL element including three or more light-emitting layers in which electrode/hole injection layer/hole transport layer/light-emitting layer/electron transport layer/electron injection layer is represented by a repeating unit (hereinafter, referred to as a "repeating unit A") may include an organic EL element that has a layered structure comprising two or more repeating units A of:
r) anode/hole injection layer/hole transport layer/light-emitting layer/electron transport layer/charge injection layer/repeating unit A/repeating unit A (optionally repeated)/cathode.

In the layered structures q and r, each layer other than the anode, the cathode, and the light-emitting layers may be omitted as needed.
The electrode is a layer that generates holes and electrons when an electric field is applied thereto. Examples of a material that constitutes the electrode may include vanadium oxide, indium tin oxide (ITO), and molybdenum oxide.

In the organic EL element, all layers at either side of each light-emitting layer can transmit light to emit light from the light-emitting layer. Specifically, for example, when the organic EL element has a structure of anode/charge injection layer/hole transport layer/light-emitting layer/electron transport layer/electron injection layer/cathode/sealing member, all of the anode, the charge injection layer, and the hole transport layer are to be light-transmittable to produce a so-called bottom emission type element, or all of the electron transport layer, the charge injection layer, the cathode, and the sealing member are to be light-transmittable to produce a so-called top emission type element. Moreover, when the organic EL element has a structure of cathode/electron injection layer/electron transport layer/light-emitting layer/hole transport layer/hole injection layer/anode/sealing member, the cathode, all of the electron injection layer, and the electron transport layer are to be light-transmittable to produce a so-called bottom emission type element, or all of the hole transport layer, the hole injection layer, the anode, and the sealing member are to be light-transmittable to produce a so-called top emission type element. The layers that can transmit light preferably have a visible light transmittance from the light-emitting layer to the layer from which light is emitted of equal to or more than 30 percent. For an element required to emit light in the ultraviolet or infrared range, transmittance at such ranges is preferably equal to or more than 30 percent.

The organic EL element may further comprise an insulating layer having a film thickness of equal to or less than 2 nanometers adjacent to the electrodes to improve adhesion to the electrodes and the charge injection from the electrodes. A thin buffer layer may also be inserted directly on at least one layer out of the charge injection layer, the charge transport layer, and the light-emitting layer to, for example, improve adhesion at the interface or to prevent mixing.
The order and the number of layers to be laminated and the thickness of each layer can be decided appropriately by taking into consideration light-emitting efficiency and element life.

The material of and the forming method of each layer that constitutes the organic EL element are described more specifically below.

### <Anode>

For the anode of the organic EL element, a transparent electrode capable of transmitting light is preferably used because such an electrode enables the element to emit light through the anode. For such a transparent electrode, a thin film of metal oxides, metal sulphides, and metals, all of which have high electric conductivity, with high transmittance can be suitably utilized and is used by being appropriately selected depending on the organic layer used. Specifically, a thin film composed of indium oxide, zinc oxide, tin oxide, ITO, or indium zinc oxide (IZO); gold, platinum, silver, copper, aluminum, or an alloy containing at least one member of these metals; or the like is used. For the anode, a thin film composed of ITO, IZO, or tin oxide is suitable for use in terms of high light transmittance and easy patterning. Examples of a manufacturing method of the anode may include a vacuum deposition method (including an electron-beam evaporation method in the embodiment described above), a sputtering method, an ion plating method, and a plating method. An organic transparent conductive film of polyaniline or a derivative thereof, polythiophene or a derivative thereof, or the like may be used as the anode. A thin film composed of a mixture containing at least one member selected from the group consisting of the material used for the organic transparent conductive film, metal oxides, metal sulphides, metals, and carbon materials such as carbon nanotube may be used for the anode.
For the anode, a material that reflects light may be used. For such material, metals, metal oxides, and metal sulphides all of which have a work function of equal to or more than 3.0 electron volts are preferred.

The film thickness of the anode can be appropriately selected in consideration of light transparency and electric conductivity and is, for example, 5 nanometers to 10 micrometers, preferably, 10 nanometers to 1 micrometer, and more preferably, 20 nanometers to 500 nanometers.

### <Hole injection layer>

The hole injection layer may be provided at a position between the anode and the hole transport layer or between the anode and the light-emitting layer. Material for the hole injection layer that constitutes the hole injection layer is not particularly limited, and a publicly known material may be appropriately used. Examples of the material for the hole injection layer may include: phenylamines; starburst-type amines; phthalocyanines; a hydrazone derivative; a carbazole derivative; a triazole derivative; an imidazole derivative; an oxadiazol derivative having an amino group; oxides such as vanadium oxide, tantalum oxide, tungsten oxide, molybdenum oxide, ruthenium oxide, and aluminum oxide; amorphous carbon; polyaniline; and a polythiophene derivative. The thickness of such a hole injection layer is preferably about 5 nanometers to 300 nanometers. A thickness less than the lower limit tends to make manufacture difficult. On the other hand, a thickness exceeding the upper limit tends to increase the driving voltage and voltage applied to the hole injection layer.

### <Hole transport layer>

Material for the hole transport layer that constitutes the hole transport layer is not particularly limited, and examples of the material may include: aromatic amine derivatives such as N,N'-diphenyl-N,N'-di(3-methylphenyl)4,4'-diaminobiphenyl (TPD) and NPB (4,4'-bis[N-(1-naphthyl)-N-phenylamino]biphenyl), polyvinyl carbazole or a derivative thereof, polysilane or a derivative thereof, a polysiloxane derivative having an aromatic amine at the side chain or the main chain, a pyrazoline derivative, an arylamine derivative, a stilbene derivative, a triphenyl diamine derivative, polyaniline or a derivative thereof, polythiophene or a derivative thereof, polyarylamine or a derivative thereof, polypyrrole or a derivative thereof, poly(p-phenylene vinylene) or a derivative thereof, and poly(2,5-thienylene vinylene) or a derivative thereof.

Among these, the hole transport material used for the hole transport layer is preferably a polymer hole transport material such as polyvinyl carbazole or a derivative thereof, polysilane or a derivative thereof, a polysiloxane derivative having an aromatic amine compound group at the side chain or the main chain, polyaniline or a derivative thereof, polythiophene or a derivative thereof, polyarylamine or a derivative thereof, poly(p-phenylene vinylene) or a derivative thereof, or poly(2,5-thienylene vinylene) or a derivative thereof, and more preferably, polyvinyl carbazole or a derivative thereof, polysilane or a derivative thereof, or a polysiloxane derivative having an aromatic amine at the side chain or the main chain. When a low molecular hole transport material is used, the material is preferably dispersed in a polymer binder.

The film-forming method of the hole transport layer is not particularly limited. When a low molecular hole transport material is used, a method of forming a film from a mixed solution of the hole transport material and a polymer binder is exemplified. When a polymer hole transport material is used, a method of forming a film from a solution may be shown as an example.

A solvent used for forming a film from the solution is not particularly limited as long as the solution dissolves the hole transport material. Examples of the solvent may include: a chlorine based solvent such as chloroform, methylene chloride, and dichloroethane; an ether based solvent such as tetrahydrofuran; an aromatic hydrocarbon based solvent such as toluene and xylene; a ketone based solvent such as acetone and methyl ethyl ketone; and an ester based solvent such as ethyl acetate, butyl acetate, or ethyl cellosolve acetate.

Examples of the available methods of forming a film from the solution may include application methods of the solution such as: coating methods, for example, a spin coating method, a casting method, a micro-gravure coating method, a gravure coating method, a bar coating method, a roll coating method, a wire bar coating method, a dip coating method, a slit coating method, a capillary coating method, a spray coating method, and a nozzle coating method; and printing methods, for example, a gravure printing method, a screen printing method, a flexo printing method, an offset printing method, a reverse printing method, and an inkjet printing method. The printing methods such as a gravure printing method, a screen printing method, a flexo printing method, an offset printing method, a reverse printing method, and an inkjet printing method are preferable in that pattern formation is easy.

When the polymer binder is used, a polymer binder that does not extremely inhibit charge transportation is preferable, and a polymer binder that does not have strong absorption of visible light is suitable for use. Examples of the polymer binder may include polycarbonate, polyacrylate, polymethyl acrylate, polymethyl methacrylate, polystyrene, polyvinyl chloride, and polysiloxane.

The thickness of the hole transport layer is not particularly limited, as it may be appropriately changed depending on the design intended, and is preferably, about 1 nanometer to 1000 nanometers. A thickness less than the lower limit tends to make manufacture difficult or tends not to fully achieve the effect of hole transport. On the other hand, a thickness exceeding the upper limit tends to increase the driving voltage and voltage applied to the hole transport layer. The thickness of the hole transport layer is, preferably, 2 nanometers to 500 nanometers, and more preferably, 5 nanometers to 200 nanometers.

### <Light-emitting layer>

The light-emitting layer is a layer that contains a light-emitting material, and an organic light-emitting layer is a layer that contains an organic compound as the light-emitting material. The organic light-emitting layer generally contains an organic substance that mainly emits fluorescence or phosphorescence (a low molecular compound and a macromolecular compound). The light-emitting layer may further contain a dopant material. Examples of a material that forms the light-emitting layer capable of being used in the present invention include the following pigment materials, metal complex materials, polymer materials, and dopant materials.

### [Pigment materials]

Examples of the pigment materials may include a cyclopendamine derivative, a tetraphenyl butadiene derivative compound, a triphenyl amine derivative, an oxadiazole derivative, a pyrazoloquinoline derivative, a distyrylbenzene derivative, a distyrylarylene derivative, a pyrrole derivative, a thiophene ring compound, a pyridine ring compound, a perynone derivative, a perylene derivative, an oligothiophene derivative, an oxadiazole dimmer, and a pyrazoline dimmer.

### [Metal complex materials]

Examples of the metal complex materials may include metal complexes such as an iridium complex and a platinum complex that emit light from the triplet excited state, and an alumiquinolinol complex, a benzoquinolinole beryllium complex, a benzoxazolyl zinc complex, a benzothiazole zinc complex, an azomethyl zinc complex, a porphyrin zinc complex, and an europium complex. Other examples of the metal complex material include a metal complex that has a central metal of Al, Zn, Be, a scarce-earth metal such as Tb, Eu, or Dy, or the like, and that has a structure of oxadiazole, thiadiazole, phenylpyridine, phenylbenzimidazole, quinoline, or the like as a ligand.

### [Polymer materials]

Examples of the polymer materials may include a polyparaphenylene vinylene derivative, a polythiophene derivative, a polyparaphenylene derivative, a polysilane derivative, a polyacetylene derivative, a polyfluorene derivative, a polyvinyl carbazole derivative, and a material in which any of the pigments or the metal complex light-emitting materials are polymerized.
Among the light-emitting materials, examples of material that emits blue light may include: a distyrylarylene derivative, an oxadiazole derivative, and their polymers; a polyvinyl carbazole derivative; a polyparaphenylene derivative; and a polyfluorene derivative. Among these, polymer materials such as a polyvinyl carbazole derivative, a polyparaphenylene derivative, and a polyfluorene derivative are preferred.
Examples of material that emits green light may include: a quinacridone derivative, a coumarin derivative, and their polymers; a polyparaphenylene vinylene derivative; and a polyfluorene derivative. Among these, polymer materials such as a polyparaphenylene vinylene derivative and a polyfluorene derivative are preferred.
Examples of material that emits red light may include: a coumarin derivative, a thiophene ring compound, and their polymers; a polyparaphenylene vinylene derivative; a polythiophene derivative, and a polyfluorene derivative. Among these, polymer materials such as a polyparaphenylene vinylene derivative, a polythiophene derivative, and a polyfluorene derivative are preferred.

### [Dopant materials]

A dopant may be added into the light-emitting layer to, for example, improve the light-emitting efficiency or to change a light-emitting wavelength. Examples of such a dopant include a perylene derivative, a coumarin derivative, a rubrene derivative, a quinacridone derivative, a squarylium derivative, a porphyrin derivative, a styryl pigment, a tetracene derivative, a pyrazolone derivative, decacyclene, and phenoxazon. The thickness of such a light-emitting layer is generally about 2 nanometers to 2000 nanometers.

### <Film-forming method of light-emitting layer>

For a film-forming method of a light-emitting layer that contains an organic compound, a method for applying a solution containing a light-emitting material onto the substrate or to the upper side of the substrate, a vacuum deposition method, a transfer method, or the like may be used. Specific examples of a solvent used for forming a film from a solution include a solvent similar to the solvent in which the hole transport material is dissolved when the film of the hole transport layer is formed from the solution described above.

Examples of the available methods for applying a solution containing the light-emitting material onto the substrate or to the upper side of the substrate may include application methods such as: coating methods, for example, a spin coating method, a casting method, a micro-gravure coating method, a gravure coating method, a bar coating method, a roll coating method, a wire bar coating method, a dip coating method, a slit coating method, a capillary coating method, a spray coating method, and a nozzle coating method; and printing methods, for example, a gravure printing method, a screen printing method, a flexo printing method, an offset printing method, a reverse printing method, and an inkjet printing method. The printing methods such as a gravure printing method, a screen printing method, a flexo printing method, an offset printing method, a reverse printing method, and an inkjet printing method are preferable in that pattern formation and color-coding in multiple colors are easily performed. For a sublimable low molecular compound, a vacuum deposition method may be used. Moreover, a method of forming the light-emitting layer only at a desired area by transfer using a laser, transfer by friction, or thermal transfer may also be used.

### <Electron transport layer>

A publicly known material may be used as the electron transport material that constitutes the electron transport layer. Examples of the material may include an oxadiazole derivative, anthraquinodimethane or a derivative thereof, benzoquinone or a derivative thereof, naphthoquinone or a derivative thereof, anthraquinone or a derivative thereof, tetracyanoanthraquinodimethane or a derivative thereof, a fluorenone derivative, diphenyldicyanoethylene or a derivative thereof, a diphenoquinone derivative, a metal complex of 8-hydroxyquinoline or of a derivative of 8-hydroxyquinoline, polyquinoline or a derivative thereof, polyquinoxaline or a derivative thereof, and polyfluorene or a derivative thereof.

Among these, an oxadiazole derivative, benzoquinone or a derivative thereof, anthraquinone or a derivative thereof, a metal complex of 8-hydroxyquinoline or of a derivative of 8-hydroxyquinoline, polyquinoline or a derivative thereof, polyquinoxaline or a derivative thereof, and polyfluorene or a derivative thereof are preferred, and 2-(4-biphenylyl)-5-(4-t-butylphenyl)-1,3,4-oxadiazole, benzoquinone, anthraquinone, tris(8-quinolinol)aluminum, and polyquinoline are further preferred.

The film-forming method of the electron transport layer is not particularly limited. When a low molecular electron transport material is used, a vacuum deposition method using powder material, or a method of forming a film from a solution or melted material is shown as examples. When a polymer electron transport material is used, a method of forming a film from a solution or melted material is shown as examples. For forming a film from a solution or melted material, a polymer binder may be used in combination. Examples of a method of forming a film of the electron transport layer from the solution may include a film-forming method similar to the method of forming a film of the hole transport layer from the solution described above.

The thickness of the electron transport layer is not particularly limited, as it may be appropriately changed depending on the design intended, and is preferably, about 1 nanometer to 1000 nanometers. A thickness less than the lower limit tends to make manufacture difficult or tends not to fully achieve the effect of hole transport.
On the other hand, a thickness exceeding the upper limit tends to increase the driving voltage and voltage applied to the electron transport layer. The thickness of the electron transport layer is, preferably, 2 nanometers to 500 nanometers, and more preferably, 5 nanometers to 200 nanometers.

### <Electron injection layer>

The electron injection layer is provided at a position between the electron transport layer and the cathode or between the light-emitting layer and the cathode. Examples of the electron injection layer may include: depending on the type of the light-emitting layer, an alkali metal and an alkaline-earth metal; alloys that contain one or more members of these metals; an oxide, a halide, and a carbonate of the metals; or mixtures of these substances. Examples of the alkali metal or the oxide, halide, and carbonate of the alkali metals may include lithium, sodium, potassium, rubidium, cesium, lithium oxide, lithium fluoride, sodium oxide, sodium fluoride, potassium oxide, potassium fluoride, rubidium oxide, rubidium fluoride, cesium oxide, cesium fluoride, and lithium carbonate. Examples of the alkaline-earth metal or the oxide, halide, and carbonate of the alkaline-earth metals may include magnesium, calcium, barium, strontium, magnesium oxide, magnesium fluoride, calcium oxide, calcium fluoride, barium oxide, barium fluoride, strontium oxide, strontium fluoride, and magnesium carbonate. Moreover, an organic metal compound doped with a metal, a metal oxide, or a metal salt, an organic metal complex compound, or mixtures thereof may also be used as a material for the electron injection layer. The electron injection layer may also be a stacked product of two or more layers. Specific examples include LiF/Ca. The electron injection layer is formed by a vapor deposition method, a sputtering method, a printing method, or the like. The film thickness of the electron injection layer is preferably about 1 nanometer to 1 micrometer.

### <Cathode material>

As a material for the cathode, any one of a material that has a small work function and facilitates electron injection into the light-emitting layer, a material having high electric conductivity, and a material having the high visible light reflectance, or a combination thereof is preferred. As metals, for example, an alkali metal, an alkaline-earth metal, a transition metal, or a 13th-group metal may be used. Specific examples of the metals may include: lithium, sodium, potassium, rubidium, cesium, beryllium, magnesium, calcium, strontium, barium, aluminum, scandium, vanadium, zinc, yttrium, indium, cerium, samarium, europium, terbium, ytterbium, gold, silver, platinum, copper, manganese, titanium, cobalt, nickel, tungsten, tin, or alloys that contain at least one member of the metals; and graphite or a graphite interlayer compound. Examples of the alloy may include a magnesium-silver alloy, a magnesium-indium alloy, a magnesium-aluminum alloy, an indium-silver alloy, a lithium-aluminum alloy, a lithium-magnesium alloy, a lithium-indium alloy, and a calcium-aluminum alloy. For the cathode, a transparent conductive electrode may be used, and, for example, a conductive metal oxide or a conductive organic substance may be used. Specifically, indium oxide, zinc oxide, tin oxide, ITO, and IZO may be used as the conductive metal oxide, and an organic transparent conductive film of polyaniline or a derivative thereof, polythiophene or a derivative thereof, or the like may be used as the conductive organic substance. The cathode may have a layered structure with two or more layers. The electron injection layer may be used as the cathode.

Although the film thickness of the cathode may be appropriately selected in consideration of electric conductivity and durability, the film thickness is, for example, 10 nanometers to 10 micrometers, preferably, 20 nanometers to 1 micrometer, and more preferably, 50 nanometers to 500 nanometers.

Examples of manufacturing methods for the cathode may include a vacuum deposition method (including an electron-beam evaporation method in the embodiment described above), a sputtering method, a chemical vapor deposition (CVD) method, an ion plating method, a laser ablation method, and a lamination method by which a metal thin film is press-bonded.

### <Second embodiment>

A second embodiment of the present invention is described with reference to Fig. 2. Fig. 2 is a sectional schematic of an organic EL element 2 of the second embodiment (hereinafter, referred to as an "element of the second embodiment"). In Fig. 2, the same numerals as those in Fig. 1 are given to the same or similar components as or to those in the first embodiment, and the points different from the first embodiment are mainly described below.

In the organic EL element 2, a highly thermally radiative layer 61 is provided on the face outside of a sealing substrate 31, that is, at the face on the side opposite to the layered body 20. A glass substrate or a sheet material having plasticity is used for the sealing substrate 31, and the sealing substrate 31 adheres to the supporting substrate 10. In other words, as illustrated in the organic EL element 2, the highly thermally conductive and radiative layer 61 may be provided on the side of the sealing substrate 30.

### <Third embodiment>

A third embodiment of the present invention and modified examples are described with reference to Fig. 3-1 to Fig. 3-5. Fig. 3-1 is a sectional schematic of an organic EL element 3A of the third embodiment (hereinafter, referred to as an "element of the third embodiment"). In Fig. 3-1, the same numerals as those in Fig. 1 are given to the same or similar components as or to those in the first embodiment, and the points different from the first embodiment are mainly described below.

In the organic EL element 3A, a highly thermally conductive and radiative layer 63 is provided on the face outside of the supporting substrate. The highly thermally conductive and radiative layer 63 is composed of two layers. One of the layers is a black coating layer 63a, and the other is an aluminum layer 63b. Heat is conducted to the supporting substrate 10 due to the heat generation of the organic light-emitting layer. Heat is prone to remain in the supporting substrate 10 particularly when a material having a low thermal conductivity, such as a glass substrate, is used for the supporting substrate 10. However, in the organic EL element 3A, the aluminum layer 63b having a high thermal conductivity is provided to be in contact with the supporting substrate 10, which promotes the dispersion of heat distribution both in the supporting substrate 10 and the aluminum layer 63b, and helps to release heat to the outside of the supporting substrate 10. The black coating layer 63a formed by being coated with black paint is provided on the face outside of the aluminum layer 63b to facilitate radiation of heat transferred to the black coating layer 63a to the exterior. In the organic EL element 3A, the black coating layer 63a is provided on the side of the supporting substrate, and therefore, the organic EL element 3A is a top emission type that emits light from the side of the sealing substrate.

The method of providing the highly thermally conductive and radiative layer 63 at the supporting substrate 10 is not particularly limited. In one example of the method, a black paint is applied to the face at one side of an aluminum sheet to prepare the sheet on which the black coating layer 63a is formed, and then the sheet is bonded to the supporting substrate 10 using an adhesive or the like (not illustrated). In an alternative embodiment, aluminum is evaporated onto the supporting substrate 10 in advance and then a black paint is applied on top of that to form a black paint layer.

Fig. 3-2 illustrates an organic EL element 3B as a modified example of the third embodiment. In the organic EL element 3A, the highly thermally conductive and radiative layer 63 is provided only at one face of the supporting substrate 10. However, in the organic EL element 3B, the highly thermally conductive and radiative layer 63 is provided on both faces of the supporting substrate 10. As described above, by providing the highly thermally conductive and radiative layers 63 at both faces of the supporting substrate 10, heat generated from the layered body 20 as a heat source can be transferred more smoothly to the whole of the supporting substrate 10, and the thermal dispersibility can further be improved. In the example illustrated in Fig. 3-2, the supporting substrate 10 and the highly thermally conductive and radiative layers 63 are provided in the following order from the layered body 20 to the outside (in the drawing, from the layered body 20 to the lower side).

### (I) aluminum layer 63b/black coating layer 63a/supporting substrate 10/black coating layer 63a/aluminum layer 63b

The positions of the black coating layer 63a and the aluminum layer 63b may be changed due to, for example, the design for the electrode formation. For example, as in the modified example illustrated in Fig. 3-3, the supporting substrate and the highly thermally conductive and radiative layers may be provided in the following order from the layered body 20 (not illustrated). In Fig. 3-3 to Fig. 3-5, the upper structures such as the layered body 20 are the same as or similar to the structure of Fig. 3-2 and thus are omitted.

### (II) black coating layer 63a/aluminum layer 63b/supporting substrate 10/aluminum layer 63b/black coating layer 63a

Moreover, the supporting substrate and the highly thermally conductive and radiative layers may be laminated in the following orders of (III), (IV), and (V) (not illustrated).

### (III) black coating layer 63a/aluminum layer 63b/supporting substrate 10/black coating layer 63a/aluminum layer 63b

### (IV) aluminum layer 63b/black coating layer 63a/supporting substrate 10/aluminum layer 63b/black coating layer 63a

### (V) aluminum layer 63b/black coating layer 63a/supporting substrate 10/black coating layer 63a/aluminum layer 63b/black coating layer 63a

From the viewpoint of heat dissipation properties, the order illustrated in (V) is preferred.

Fig. 3-4 illustrates still another modified example of the element of the third embodiment. In the organic EL element 3B, the highly thermally conductive and radiative layer 63 that comprises two layers of the black coating layer 63a and the aluminum layer 63b are provided. In contrast, in the modified example illustrated in Fig. 3-4, the black coating layer 63a is provided on both faces of the aluminum layer 63b. Such an embodiment of providing the black coating layers 63a at both faces is an exemplary embodiment to further enhance heat dissipation properties.

Fig. 3-5 illustrates still another modified example of the element of the third embodiment. In the modified example illustrated in Fig. 3-5, only the aluminum layer 63b is provided on the face of the supporting substrate 10 on the side of the layered body (at the upper face of the supporting substrate 10 in Fig. 3-5). The modified example may be employed when the black coating layer does not have to be provided on the face at the inner side of the organic EL element.

Fig. 3-6 illustrates still another modified example of the element of the third embodiment. In the modified example illustrated in Fig. 3-6, the black coating layer 63a and the aluminum layer 63b are provided on the main face of the supporting substrate 10 on the side of the layered body (at the upper face of the supporting substrate 10 in Fig. 3-6).

### <Fourth embodiment>

A fourth embodiment of the present invention is described with reference to Fig. 4. Fig. 4 is a sectional schematic of an organic EL element 4A of the fourth embodiment (hereinafter, referred to as an "element of the fourth embodiment"). In Fig. 4, the same numerals as those in Fig. 1 are given to the same or similar components as or to those in the third embodiment, and the points different from the first embodiment are mainly described below.

In the organic EL element 4A, the highly thermally conductive and radiative layer 63 is not provided on the side of the supporting substrate but rather is provided on the upper face of the sealing substrate 30. As described above, the highly thermally conductive and radiative layer 63 may be provided on the side of the sealing substrate. The organic EL element 4A is a bottom emission type element that emits light from the side of the supporting substrate 10.

### 2. Organic EL device

The organic EL device of the present invention is a device on which one or more organic EL elements described above are mounted. The organic EL device can be used for, for example, a planar light source, a segment display device, a dot-matrix display device, the backlight of a liquid crystal display device, or an illumination device. The organic EL device of the present invention has excellent heat dissipation properties of the element. Therefore, the organic EL device has little brightness fluctuation and can be a device with excellent durability over time. Particularly, illumination devices are required to have high brightness, thus are required to be applied with high electric power, and tend to have a large heat value. For this reason, the organic EL device of the present invention is particularly suitable for illumination devices.

A plane anode and a plane cathode may be disposed to overlap with each other so as to emit plane light using the organic EL device on which the organic EL element is mounted. Examples of a method of emitting patterned light may include a method of setting a mask having a patterned hole at the surface of the plane light-emitting element, a method of forming an organic layer at a non-light-emitting portion to be extremely thick so as not to substantially emit light, and a method of forming any one of an anode and a cathode or both electrodes in a patterned shape. A pattern is formed using any of these methods and is arranged to enable several electrodes to be independently ON/OFF, and thus, a segment display device that can display numerals, letters, simple symbols, and the like can be produced. A substrate for a passive matrix in which both the anode and the cathode are formed in stripe shapes and arranged to be orthogonal to each other, or a substrate for an active matrix that performs control pixel by pixel, in which a thin film transistor is arranged, to produce a dot-matrix device. Partial color display and multicolor display are possible by a method for applying light-emitting materials having different luminous colors separately or a method of using color filters or fluorescence conversion filters. These display elements can be used for a display device of a computer, a television, a mobile terminal, a portable cellular phone, a car navigation device, or a viewfinder of a video camera, for example.

Moreover, the plane light-emitting device is a self light-emitting thin type and can be suitable for use in a plane light source for the backlight of a liquid crystal display device or a plane illuminating light source. When a flexible substrate is used, the plane light-emitting device can also be used for a curved plane light source and a curved plane display device.

### Examples

Te present invention is described in more detail below with reference to verification experiments and Examples, although the present invention is not limited to Examples and the like.

The verification experiments were performed using test equipment as illustrated in Fig. 5. The present invention is considered not to substantially depend on the structure of the layered body portion of the organic EL element, and therefore, the evaluations were performed using a self-made point heater as a heat source and using glass, an aluminum sheet covered with a material having a high thermal emissivity, and the like. As illustrated in Fig. 5, a hot plate 81 is provided on a test board 80, and a cylindrical heat conducting portion 83 is provided at the central portion of the hot plate 81. The heat conducting portion 83 is made of brass, and a thermal insulating sheet 82 is wound around the perimeter of a side surface of the heat conducting portion 83. A test substrate supporting glass 12 is provided at the top-end portion of the heat conducting portion 83. A test substrate 15 as an object under test is placed on the test substrate supporting glass 12. A temperature sensor 84 measures the temperature of the upper surface portion of the test substrate 15 from the above. The radiant heat is measured at the upper surface portion of the test substrate 15.

Fig. 6 is a plane schematic of the test substrate 15 placed on the test substrate supporting glass 12. Numerals A to K illustrated on the test substrate 15 indicate measurement positions measured by the temperature sensor 84 from the above. The broken line at the central portion is a perspective drawing of the top facet of the heat conducting unit 83 positioned under the test substrate supporting glass 12. The thermal diffusion property of the test substrate 15 can be measured by providing the heat source at the central part in such a manner, and by measuring a plurality of positions from one corner portion of the test substrate 15 to the central portion and further to the other diagonal corner portion.

The evaluation of each test substrate was performed in the following manner. For the heat dissipation effect, the reduced level of the maximum temperature (at the central portion of the test substrate) was used as an index. Specifically, the maximum temperature (temperature at the central portion) of the test substrate of Comparative Test Example 1 (glass substrate alone) was assumed as the maximum value of the maximum temperature. The reduced level was obtained as a difference by subtracting this maximum value from the maximum temperature at the central portion of other test substrates. This indicates that thermal radiation properties improve in correspondence with a decrease in the maximum temperature and an increase in the difference of the maximum temperature in the negative direction. For the thermal uniformity (thermal dispersibility), the temperature distribution represented by temperature at each measurement position in each test substrate was used as an index. This indicates that thermal uniformity becomes excellent in correspondence with a decrease in variation in the temperature distribution in the test substrate.

### <Test Example 1>

In Test Example 1, the test substrate illustrated in Fig. 7-1 was used. For the test substrate of Test Example 1, a substrate in which an aluminum sheet having a high thermal conductivity, coated in black, and having a high thermal emissivity, and a sheet (trade name: Kobe honetsu alumi (KS750); manufactured by Kobe Steel, Ltd.; thermal conductivity: 230 W/mK; thermal emissivity: 0.86) composed of an adhesive material for laminating with a glass substrate were provided as a glass substrate 11 (a thickness of 0.7 millimeter) was manufactured. The test substrate of Test Example 1 is constituted as a layered body in which glass substrate 11/aluminum layer 63b/black coating layer 63a are laminated on the test substrate supporting glass 12 in this order.

The temperature when the test glass substrate of Comparative Test Example 1 became 90 degrees Celsius was used as a standard, and the set temperature of the hot plate was set to be the standard temperature to heat the test substrate. When the fluctuations of the temperature at a measurement point was in a state that settled in a range of ±0.2 degree Celsius, the temperature was judged to be stable. The temperatures at the positions A to K illustrated in Fig. 6 were measured using the temperature sensor 84.

### <Test Example 2>

The thermal radiation properties and the thermal uniformity of the test substrate were tested in a manner similar to Test Example 1 except that as the test substrate, the test substrate illustrated in Fig. 7-2 was used. As illustrated in Fig. 7-2, in the test substrate of Test Example 2, highly thermally conductive and radiative layers were adhered to both faces of the glass substrate. In other words, the test substrate of Test Example 3 is constituted as a layered body in which black coating layer 63a/aluminum layer 63b/glass substrate 11/aluminum layer 63b/black coating layer 63a are laminated on the test substrate supporting glass 12 in this order.

### <Test Example 3>

The thermal radiation properties and the thermal uniformity of the test substrate were tested in a manner similar to Test Example 1 except that as the test substrate, the test substrate illustrated in Fig. 7-3 was used. As illustrated in Fig. 7-3, in the test substrate of Test Example 3, a highly thermally conductive and radiative layer was adhered to the face of the glass substrate at the outer side (the side opposite to the side on which a layered body was to be formed), while only an aluminum sheet was adhered to the face at the inner side. In other words, the test substrate of Test Example 3 is constituted as a layered body in which aluminum layer 63b/glass substrate 11/aluminum layer 63b/black coating layer 63a are laminated on the test substrate supporting glass 12 in this order.

### <Comparative Test Example 1>

The thermal radiation properties and the thermal uniformity of the test substrate were tested in a manner similar to Test Example 1 except that as the test substrate, the test substrate illustrated in Fig. 7-4 was used. As illustrated in Fig. 7-4, the glass substrate 11 alone was used for the test substrate of Comparative Test Example 3.

### <Comparative Test Example 2>

The thermal radiation properties and the thermal uniformity of the test substrate were tested in a manner similar to Test Example 1 except that as the test substrate, the test substrate illustrated in Fig. 7-5 was used. As illustrated in Fig. 7-5, in the test substrate of Comparative Test Example 2, only an aluminum sheet was adhered to the face of the glass substrate 11 on the side on which a layered body was to be formed. The test substrate 15 of Comparative Test Example 2 is constituted as a layered body in which aluminum layer 63b/glass substrate 11 are laminated on the test substrate supporting glass 12 in this order.

### <Evaluation>

The results of the verification test of Test Examples 1 to 3 and Comparative Test Examples 1 and 2 are given in Fig. 8 and Table 1.

**[Table 1]**

| MAXIMUM TEMPERATURE AND TEMPERATURE DIFFERENCE BETWEEN MAXIMUM AND MINIMUM | | |
|---|---|---|
| TEST NUMBER | MAXIMUM TEMPERATURE (CENTER) | TEMPERATURE DIFFERENCE BETWEEN MAXIMUM AND MINIMUM |
| TEST EXAMPLE 1 | 81.0°C (-9.0 °C) | 10.2°C |
| TEST EXAMPLE 2 | 72.5 °C (-17.5 °C) | 4.1°C |
| TEST EXAMPLE 3 | 78.4 °C (-11.6 °C) | 7.0°C |
| COMPARATIVE TEST EXAMPLE 1 | 90.0 °C | 42.6 °C |
| COMPARATIVE TEST EXAMPLE 2 | 87.3°C (-2.7°C) | 35.9 °C |

Table 1 indicates a list of the maximum temperatures and the temperature differences between maximum and minimum. The maximum temperature is the value that indicates the highest temperature of each test substrate as measures at the central portion of each test substrate. The values in the parentheses are values obtained by subtracting the maximum temperature of Comparative Test Example 1 (that is, 90.0 degrees Celsius) from the highest temperature of each test substrate. The values of the temperature between maximum and minimum indicate a difference between the maximum value and the minimum value in the same test substrate, representing indexes for thermal uniformity (thermal dispersibility).

As indicated in Table 1, the maximum temperatures of all of Test Examples 1 to 3 were lower than those of Comparative Test Examples 1 and 2, and it was revealed that in Test Examples 1 to 3, a greater amount of heat escaped from the central portion with the maximum temperature. Moreover, Comparative Test Examples 1 and 2 had larger values of the temperature difference between maximum and minimum, and it was revealed that in Comparative Test Examples 1 and 2, the temperature difference in the same substrate was large.

As illustrated in Fig. 8, in Comparative Test Examples 1 and 2, the measurement positions A to C and I to K at the peripheral portions of the test substrates were about 40 degrees Celsius to 55 degrees Celsius. In contrast, the measurement positions D to H at the central portions of the substrates were about 80 degrees Celsius to 90 degrees Celsius, and thus, a remarkable temperature difference was observed. As is apparent from the above, the test substrates subjected to Comparative Test Examples 1 and 2 had low thermal uniformity (low thermal dispersibility).

By contrast, in Test Examples 1 to 3, it was revealed that the temperature distribution from the measurement positions A through K was leveled in a range of about 70 degrees Celsius to 80 degrees Celsius. In other words, the test substrates subjected to Test Examples 1 to 3 had high thermal uniformity (high thermal dispersibility).

### <Example 1> Manufacture of bottom emission type organic EL element

A bottom emission type organic EL element was manufactured by the following method. A 200x200 millimeters glass substrate on which a plurality of ITO transparent conductive film patterns and of Cr patterns for an organic EL element having a size of 30x40 millimeters were formed was manufactured. An ITO transparent conductive film was formed to have a film thickness of about 150 nanometers by a sputtering method, and 200 nanometers of Cr was patterned by a sputtering method.

A film was formed on the glass substrate with ITO and CR patterns by a spin coating method using a suspension of poly(3,4)ethylenedioxythiophene/polystyrene sulfonic acid (Baytron P TP AI 4083, manufactured by H.C. Starck-V TECH Ltd.). The film was dried in an oven at 200 degrees Celsius for 20 minutes to form a hole injection layer having a thickness of 60 nanometers. Subsequently, unnecessary portions of the hole injection layer at the periphery of the organic EL element were wiped off and removed using a wiper soaked in water.

An 1.5 percent by weight solution of a polymer organic light-emitting material (Lumation GP1300, manufactured by Sumation Co Ltd.) was prepared using a solvent in which cyclohexanone and xylene were mixed in a ratio of 1:1. This solution was applied onto the substrate on which the hole injection layer was formed by a spin coating method to form a light-emitting layer. Subsequently, unnecessary portions of the light-emitting layer at the periphery of the element were wiped off using an organic solvent, and then vacuum drying (heating at a temperature of about 170 degrees Celsius under a pressure of equal to or less than 1×10⁻⁴ Pascal for 15 minutes) was performed.

Subsequently, the substrate was moved into a vapor deposition chamber and was aligned with a cathode mask, and then a cathode was vapor deposited. The cathode was produced by heating metal barium by a resistance heating method to vapor deposit the metal barium to have a film thickness of 50 angstroms (5 nanometers) at a deposition rate of about 2 angstroms/sec (0.2 nm/sec), and by vapor depositing Al by an electron-beam evaporation method to have a film thickness of 1000 angstroms (100 nanometers) at a deposition rate of about 10 angstroms/sec (1 nm/sec). After the formation of the cathode, the substrate was moved from the vapor deposition chamber into a glove box under an inactive atmosphere without being exposed to the atmosphere.

A glass sealing substrate (a thickness of 0.7 millimeter) to which a material that contains a material having a high thermal conductivity and coated in black was adhered was prepared. For the material having high thermal conductivity and coated in black, an aluminum sheet having a high thermal conductivity, coated in black, and having a high thermal emissivity, and a sheet (trade name: Kobe honetsu alumi (KS750); manufactured by Kobe Steel, Ltd.; thermal conductivity: 230 W/mK; thermal emissivity: 0.86) composed of an adhesive material for bonding with a glass substrate were used. Thermosetting resin (trade name of PX681C/NC and manufactured by Robnor Resins Ltd) was used for the adhering of the material having a high thermal conductivity and coated in black with the glass sealing substrate, and the peripheral portion was assumed to be a adhering area. After application to the whole surface, the glass sealing substrate was put into a glove box under an inactive atmosphere, aligned with the substrate on which the cathode was formed, and then laminated to the substrate. The pressure was further maintained under a vacuum and then was returned to atmospheric pressure. The element substrate and the sealing substrate were fixed by heating to manufacture a macromolecular organic EL element. The viscosity of the thermosetting resin used before curing was 50 mPa•s.

### <Example 2> Manufacture of bottom emission type organic EL element

In Example 2, the combination of the materials of the element substrate and the sealing substrate is opposite to that in Example 1. In other words, a substrate to which a material that contains a material having a high thermal conductivity and coated in black is adhered is used as a supporting substrate, and a glass substrate is used as a sealing substrate to seal the whole surface. In this manner, an element that is a so-called top emission type element emitting light from the side of the sealing substrate and that has a uniform surface temperature distribution as with the element of Example 1 is able to be manufactured.

### INDUSTRIAL APPLICABILITY

As described above, the present invention is useful in an industrial field related to organic EL devices.

## Claims

1. An organic electroluminescent element comprising a supporting substrate, a sealing substrate, and a layered body comprising a pair of electrodes and an organic light-emitting layer located between the electrodes,
wherein the layered body is mounted on the supporting substrate and is surrounded by the supporting substrate and the sealing substrate to be isolated from an external environment,
a highly thermally radiative layer is provided on at least one face of the supporting substrate, or at least one face of the sealing substrate, and
the highly thermally radiative layer has a thermal emissivity of equal to or more than 0.70.

2. The organic electroluminescent element according to claim 1, wherein the thermal emissivity is equal to or more than 0.85.

3. The organic electroluminescent element according to claim 1, wherein the thermal conductivity of the highly thermally radiative layer is equal to or more than 1 W/mK.

4. The organic electroluminescent element according to claim 3, wherein the thermal conductivity is equal to or more than 200 W/mK.

5. The organic electroluminescent element according to claim 1, wherein the highly thermally radiative layer comprises a black material.

6. The organic electroluminescent element according to claim 1, wherein the highly thermally radiative layer is a laminated layer having two or more layers that comprise a highly thermally conductive layer and a layer of a black material.

7. The organic electroluminescent element according to claim 6, wherein the highly thermally conductive layer is composed of a material selected from the group consisting of aluminum, copper, silver, ceramic materials, and alloys that contains two or more members selected from these or resin having a high thermal conductivity.

8. The organic electroluminescent element according to claim 1, wherein the supporting substrate is a glass substrate, and the highly thermally radiative layer is provided on at least one face of the glass substrate.

9. The organic electroluminescent element according to claim 8, wherein the highly thermally radiative layer is provided on a face of the glass substrate on a side opposite to the layered body.

10. The organic electroluminescent element according to claim 8, wherein the highly thermally radiative layer is provided on both faces of the glass substrate.

11. The organic electroluminescent element according to claim 8, wherein the highly thermally radiative layer is provided on a face of the glass substrate on a side opposite to the layered body, and a highly thermally conductive layer is provided on a face of the glass substrate on a side of the layered body.

12. The organic electroluminescent element according to claim 1, wherein the sealing substrate is a glass substrate, and the highly thermally radiative layer is provided on at least one face of the glass substrate.

13. A display device comprising the organic electroluminescent element according to claim 1 mounted therein.

14. An illumination device comprising the organic electroluminescent element according to claim 1 mounted therein.
